# EUROPEAN PATENT SPECIFICATION

(11) **EP 0 468 377 B1**
(45) Date of publication and mention of the grant of the patent: **21.12.1994**
(21) Application number: 91112105.1
(22) Date of filing: 19.07.1991
(51) Int. Cl.: C30B 25/00, C30B 29/36

(54) **Preparation of silicon carbide whiskers**
Herstellung von Siliciumcarbid-Whiskern
Préparation de trichites en carbure de silicium

(30) Priority: 24.07.1990 US 566908
(43) Date of publication of application: 29.01.1992
(73) Proprietor: LANXIDE TECHNOLOGY COMPANY, LP, Newark, Delaware 19714-6077 (US)
(72) Inventor: Jensen, James Allen, Hockessin, Delaware 19707 (US); Rosenthal, Allan Bruce, Wilmington, Delaware 19810 (US)
(74) Representative: Lederer, Franz, Dr.

(56) References cited:
- EP-A- 0 290 258
- PATENT ABSTRACTS OF JAPAN, vol. 13, no. 56 (C-566)(3404), February 8, 1989; & JP-A-63 248 798

## Description

This invention relates to a method for the preparation of silicon carbide single crystals.

Silicon carbide whiskers are valued for their acicular morphology and single crystal structure. These characteristics lead to high strength, high elastic modulus, heat resistance and chemical stability in composite applications. The whiskers have been used as a reinforcing material for metals, plastics and ceramics, with the most desirable whiskers having a high length to diameter ratio.

A variety of methods have been described for preparing silicon carbide single crystals by reacting a silicon source with carbon. For example, U.S. Patent 4,702,901 discloses a method for growing the β-form of silicon carbide whiskers by first heating a mixture of a silicon source, a carbon source and a catalyst to or beyond the growth temperature and then cooling to or below the growth temperature to induce nucleation of whiskers at catalyst sites. Most of these processes require the addition of 25 ppm to 3 wt.% of a catalyst. When large amounts of catalyst are used, the catalyst must typically be removed after whisker formation in order to preserve the desired physical properties of the silicon carbide single crystals. Removal of impurities is a time-consuming and difficult process.

Japanese unexamined patent application 63-248,798 describes heating a mixture of silicic acid or a silicic acid compound with carbon, cooling to obtain powdered SiO₂ or a powder mixture of SiO and SiO₂, mixing with more carbon and heating a second time in a non-oxidizing atmosphere.

A process that is more time- and energy-efficient, in addition to not requiring the addition of a catalyst, would be desirable.

The process of this invention for preparing silicon carbide single crystals by reacting a silicon source with carbon at an elevated temperature under a non-oxidizing atmosphere is characterized by (1) preparing the silicon source by reacting silica gel, silicic acid or silicon dioxide with an inorganic base and a multifunctional alcohol or multifunctional phenol to produce a carbon-containing chemically activated-silicon compound and (2) heating a mixture of the silicon compound and carbon black or graphite to a temperature of 1300° to 1700°C.

The first step in the process of this invention is the reaction of a finely divided silicon source selected from silica gel, silicic acid and silicon dioxide with a strong inorganic base and a multifunctional alcohol or multifunctional phenol to form a carbon-containing chemically activated silicon compound. The term "chemically activated" refers to the fact that these compounds have a structure in which the substantially crosslinked Si-O network in the parent structure is partially broken down. Suitable inorganic bases include, but are not limited to, ammonium hydroxide, lithium hydroxide, sodium hydroxide and potassium hydroxide. Ammonium hydroxide is preferred because it decomposes and volatilizes during pyrolysis. Multifunctional alcohols and multifunctional phenols suitable for use in the process of this invention can be either monomeric or polymeric and include, for example, catechol, ethylene glycol, glycerol, 1,6-hexanediol, pentaerythritol and poly(vinyl alcohol). Preferably the alcohol or phenol will have vicinal functionality, i.e., OH groups on adjacent carbons, and low molecular weight, e.g., ethylene glycol and catechol. Monofunctional alcohols such as isopropanol and ethanol are not suitable for use in this process.

The chemically activated silicon compounds formed from alcohols or phenols with vicinal functionality can be monomeric, such as the [Si(catechol₃)]²⁻ species described in Barnum, Inorganic Chemistry, 11 (1972), 1424, or polymeric, in which the vicinal alcohol or phenol chelates to different silicon atoms. The net result of such bonding is to simplify the highly crosslinked Si-O network found in SiO₂ analogs such as silicic acid, silica gel and sand. Although not wishing to be bound by theory, such network simplification is believed to result in a high concentration of SiO gas due to facilitation of the volatilization of low molecular weight fragments during pyrolysis and subsequent nucleation of SiC via crystal growth on carbon, i.e., a vapor-solid reaction mechanism.

The activated silicon compound is then mixed with carbon black or graphite as a carbon source. When carbon black is used as the carbon source, whisker formation is not dependent on the type of carbon black used or on the amounts of metal impurities that are present, e.g., whiskers have formed using carbon black containing as much as 500 ppm and as little as 15 ppm iron as an impurity. Addition of a metal catalyst is not required. The mixture is heated to a temperature of 1300° to 1700°C in a non-oxidizing atmosphere such as, for example, argon and other noble gases.

The silicon carbide single crystals produced by the process of this invention are generally in the form of whiskers, although there may be small amounts of single crystal particulates or fibers dispersed in the whiskers. A fiber is usually defined as a single crystal having an aspect ratio greater than 10:1. While the process described here generally results in materials having an aspect ratio less than 10, the fabrication of materials having an aspect ratio greater than 10 is not precluded. The single crystals can be mixed with metals, plastics and ceramic powders such as alumina or silicon nitride to form tough, strong composites.

### Example 1

Silica gel (2.5 g), catechol (15.6 g) and NH₄OH (125 ml) are combined in a nitrogen-filled flask. The contents are stirred to dissolve the catechol and stirring is continued for seven hours at room temperature. The initial green color of the solution changes to brown as the reaction proceeds and a white product precipitates from solution. The solution is allowed to stand overnight to ensure complete reaction. The product is isolated by filtration under nitrogen, washed with cold (0°C) NH₄OH, and transferred to a Schlenk flask. The precipitate is washed with diethyl ether (170 ml) to remove excess catechol, filtered and dried under vacuum. A white powder is isolated with a yield of 3.0 g.

The activated silicon compound prepared as described above (1.0 g) is mixed with 0.25 g of carbon black powder. The mixture is then fired in a carbon crucible under argon to 1500°C at 5°C/min and held at this temperature for four hours. The sintered powder is dark green in color and has a fine texture. X-ray-diffraction indicates the presence of single crystal silicon carbide.

### Example 2

Silica gel (5.0 g), ethylene glycol (25 ml) and ammonium hydroxide (50 ml) are combined and stirred for fifteen hours at room temperature and for fifteen hours at 80°C. The solid product is isolated by filtration, washed with isopropanol and dried in air. A white, finely divided powder is isolated with a yield of 8.3 g.

The reaction product (1.0 g) prepared as described above is mixed with 0.20 g of carbon black powder. The powder is then fired in a carbon crucible under argon to 1500°C at 5°C/min and held at this temperature for two hours. A fine dark green powder is formed.

X-ray diffraction (XRD) data verify that pure crystalline β-SiC forms with no other phase present. Scanning electron microscopy (SEM) indicates both single crystals and particulates are formed. Energy dispersive X-ray (EDX) data show that only Si is present, indicating no elemental impurities with atomic weight higher than silicon are present above the detection limit.

### Example 3

The silica gel/ethylene glycol reaction product (2.5 g) prepared as described in Example 2 is mixed with 0.5 g of ultrapure carbon black containing less than 15 ppm iron as an impurity, and fired in a carbon crucible under argon to 1500°C at 5°C/min. and held at this temperature for four hours. X-ray diffraction and electron microscopy show the formation of single crystal SiC whiskers.

### Comparative Example 1

In this example, no chemically activated silicon compound is used in order to substantiate the importance of the activated silicon compound in the formation of silicon carbide single crystals.

A sample containing 2.5 g silica gel and 0.5 g carbon black powder is fired under argon to 1500°C and held at this temperature for two hours. XRD data verify the presence of α-cristobalite and a small concentration of cubic and hexagonal SiC. No whiskers are detected from the SEM data.

### Comparative Example 2

This example illustrates the inability of monofunctional alcohols to form the activated silicon compounds used in the process of this invention.

Silica gel (5.0 g), ethanol (25 ml) and NH₄OH (50 ml) are combined and heated to 60°C for 14 hours. The solution is stirred an additional 15 hours at room temperature. The solid product is isolated by filtration, washed with distilled water and air dried. The yield is 4.4 g.

The solid product (2.5 g) is mixed with 0.5 g of carbon black containing less than 15 ppm iron as an impurity and fired in a carbon crucible to 1500°C at 10°C/min under argon and held at this temperature for four hours. X-ray diffraction data show that α-cristobalite is formed.

## Claims

1. A method for preparing silicon carbide single crystals by reacting a silicon source with carbon at an elevated temperature under a non-oxidizing atmosphere, characterized by (1) preparing the silicon source by reacting silica gel, silicic acid or silicon dioxide with an inorganic base and a multifunctional alcohol or multifunctional phenol to produce a carbon-containing chemically activated silicon compound, and (2) heating a mixture of the silicon compound and carbon black or graphite to a temperature of 1300° to 1700°C.

2. The process of claim 1, further characterized in that the single crystal is a whisker.

3. The process of claims 1 or 2, further characterized in that the inorganic base is ammonium hydroxide.

4. The process of any of the preceding claims, further characterized in that the multifunctional alcohol or phenol is a diol.

5. The process of claim 4, further characterized in that the diol is ethylene glycol.

6. The process of claim 4, further characterized in that the diol is catechol.

## Patentansprüche

1. Verfahren zur Herstellung von Siliciumcarbid-Einkristallen durch Umsetzung einer Siliciumquelle mit Kohlenstoff bei einer erhöhten Temperatur unter einer nichtoxidierenden Atmosphäre, gekennzeichnet durch (1) Herstellen der Siliciumquelle durch Umsetzung von Kieselgel, Kieselsäure oder Siliciumdioxid mit einer anorganischen Base und einem multifunktionellen Alkohol oder multifunktionellen Phenol, um eine Kohlenstoff enthaltende, chemisch aktivierte Siliciumverbindung zu erzeugen, und (2) Erhitzen einer Mischung der Siliciumverbindung und Ruß oder Graphit auf eine Temperatur von 1300° bis 1700°C.

2. Verfahren nach Anspruch 1, dadurch gekennzeichnet, daß der Einkristall ein Whisker ist.

3. Verfahren nach Anspruch 1 oder 2, dadurch gekennzeichnet, daß die anorganische Base Ammoniumhydroxid ist.

4. Verfahren nach einem der vorstehenden Ansprüche, dadurch gekennzeichnet, daß der multifunktionelle Alkohol oder das Phenol ein Diol ist.

5. Verfahren nach Anspruch 4, dadurch gekennzeichnet, daß das Diol Ethylenglycol ist.

6. Verfahren nach Anspruch 4, dadurch gekennzeichnet, daß das Diol Catechol ist.

## Revendications

1. Procédé pour préparer des monocristaux de carbure de silicium en faisant réagir une source de silicium avec du carbone à une température élevée sous une atmosphère non oxydante, caractérisée par les étapes consistant:
(1) à préparer la source de silicium en faisant réagir un gel de silice, de l'acide silicique ou du dioxyde de silicium avec une base minérale et un alcool multifonctionnel ou un phénol multifonctionnel pour produire un composé de silicium chimiquement activé contenant du carbone, et
(2) à chauffer un mélange du composé de silicium et du noir de carbone ou du graphite à une température comprise entre 1 300°C et 1 700°C.

2. Procédé selon la revendication 1, caractérisé de plus en ce que le monocristal est une trichite.

3. Procédé selon la revendication 1 ou 2, caractérisé de plus en ce que la base minérale est l'hydroxyde d'ammonium.

4. Procédé selon l'une quelconque des revendications précédentes, caractérisé de plus en ce que l'alcool multifonctionnel ou le phénol est un diol.

5. Procédé selon la revendication 4, caractérisé de plus en ce que le diol est l'éthylèneglycol.

6. Procédé selon la revendication 4, caractérisé de plus en ce que le diol est le catéchol.
